## Europäisches Patentamt
## European Patent Office
## Office européen des brevets

(11) Publication number: **0 163 822**
**B1**

## EUROPEAN PATENT SPECIFICATION

(45) Date of publication of patent specification: **07.03.90**

(51) Int. Cl.⁵: **H 01 M 10/48**

(21) Application number: **85102959.5**

(22) Date of filing: **14.03.85**

(54) A storage battery.

(30) Priority: **06.06.84 ES 279755 u**

(43) Date of publication of application:
**11.12.85 Bulletin 85/50**

(45) Publication of the grant of the patent:
**07.03.90 Bulletin 90/10**

(84) Designated Contracting States:
**AT BE CH DE FR GB IT LI LU NL SE**

(56) References cited:
**FR-A-2 565 415**
**GB-A- 971 128**
**GB-A-1 115 568**
**GB-A-1 262 016**
**GB-A-2 060 181**
**US-A-4 237 198**
**US-A-4 289 836**

**PATENTS ABSTRACTS OF JAPAN, vol. 8, no. 209 (E-268)1646r, 22nd September 1984; & JP - A - 59 94 381 (YUASA DENCHI K.K.) 31-05-1984**

(73) Proprietor: **SOCIEDAD ESPANOLA DEL ACUMULADOR TUDOR, S.A.**
**Condesa de Venadito, 1**
**28027 Madrid (ES)**

(72) Inventor: **Garcia Munoz, Antonio**
**C/Pescaderia 23 Alcalé de Henares**
**Madrid (ES)**

(74) Representative: **Prato, Roberto et al**
**STUDIO TORTA Società Semplice Via Viotti 9**
**I-10121 Torino (IT)**

Courier Press, Leamington Spa, England.

EP 0 163 822 B1

**Description**

The present invention relates to a storage battery in the box or container of which an usually in its upper portion a housing is arranged, connected with the output terminals, so that inside the housing an electronic circuit is arranged, adapted to indicated by means of some luminescent diodes if the voltage of the battery is above or below of a value estimated as a mean in the charge condition of a battery. In order to avoid failures of charge in an accumulator, a push button is provided for the supply of said circuit, through the operation of which, the corresponding diode lights.

At present, are provided indicators of the battery voltage usually placed between the installation supplied by the accumulator, but this solution is not frequent, since the introduction of a voltmeter makes the unit expensive.

On the other hand, and especially in simple installations, the voltmeter can mean a complication, since the user of this installation cannot know the state of the battery until he starts it, originating the consequent troubles when the battery results low in charge.

In other cases in which a battery under load is used for any generator not signalled, it is further impossible to known the condition of the battery if the instrumentation or the signalling are not available, so that the failure of the generator can involve an interruption in the performance provided by the battery.

The use of the devices incorporated to its battery which continually prove if the voltage provided by it is found above a value or predetermined value is already known. Among them are the ones corresponding to the U.S. Patents: US—A—4 289 836 and US—A—4 237 198; in particular, in the first it is shown an electric battery comprising a container into which the electric elements are arranged, and in the upper lid of which is placed a hermetically closed housing for a circuit comprising a microprocessor which compares a fixed and stable voltage, produced from the battery, with another voltage proportional to the output voltage of the battery. In the second document (US—A—4 237 198) it is shown a battery with a state of charge indication, which utilizes a LED-display.

The aim of the present invention is to provide for an electric battery having a state of charge indication, based through the said principle of comparison of voltages, and which combines the low cost of the materials used with the possibility of fulfilling the above-mentioned features, in which it is only necessary to know if the battery is utilizable or if it is going out of charge.

The comparative cost of the electronic device with the accumulator is so low, that whatever battery can be supplied by the plant integral with said device. Further the electronic circuit in its hermetical housing, is adaptable to any existing battery.

According to the present invention, there is provided an electrical battery comprising a box or container into which the electric elements are arranged, said box or container presenting preferably in the upper lid, a hermetically closed housing into which a plurality of interconnected electronic components are placed, said components forming a circuit comprising a voltage comparator which compares a fixed and stable voltage, produced from the battery, with another voltage proportional to the output voltage of the battery, said comparator controlling signalling means which indicate the condition of a low charge or the good condition of the charge of said battery, characterized in that the said circuit contained in the said hermetical housing comprises a resistive voltage divider with its central point preferably adjustable, applied to one of the inputs of said voltage comparator, to the other input of which is coupled the stable voltage produced by a Zener diode in series with a silicon diode and supplied by a resistor, the output of the said comparator being connected to two luminescent diodes of different colours in parallel and with inverted polarity at the joining point of two resistors connected with the other terminal respectively to the positive and the negative poles of the battery, all the said circuit being supplied by the terminals of the battery through a push-button switch actuatable for checking purposes.

In particular, it is provided a voltage comparator, so that a comparison between the voltage of the battery and another produced by the same and having a lower value is made; the result of the comparison is amplified and converted to a positive or negative level relative to a predetermined value. These levels are applied to two LED type luminescent diodes with inverted connection and having clearly different colours, for instance red for low battery and green for normal battery. The threshold of actuation of either LED is accomplished according to the features of the producer of the accumulators or the type of the same. In this way, the circuit fits to each battery. A preferred value can be 12, 35 V for a battery of a rated voltage of 12 V. In this case, if the voltage of the battery is V:

if V≥ 12, 35, battery in good condition and therefore the green diode lights;

if V<12, 35, the battery is undervoltage and therefore low in charge, so that the red diode lights.

Underneath a level of voltage of about 8 volts, the circuit is inactive and neither LED lights, signalling therefore a failure of the battery.

For a better understanding of the present invention there is now given a detailed description of the same, with reference to the attached drawings, in which:

figure 1 illustrates the electronic circuit according to the invention,

figures 2 and 3 illustrate in elevation and in plan, respectively, a storage battery containing a housing into which the electronic circuit of figure 1 is arranged.

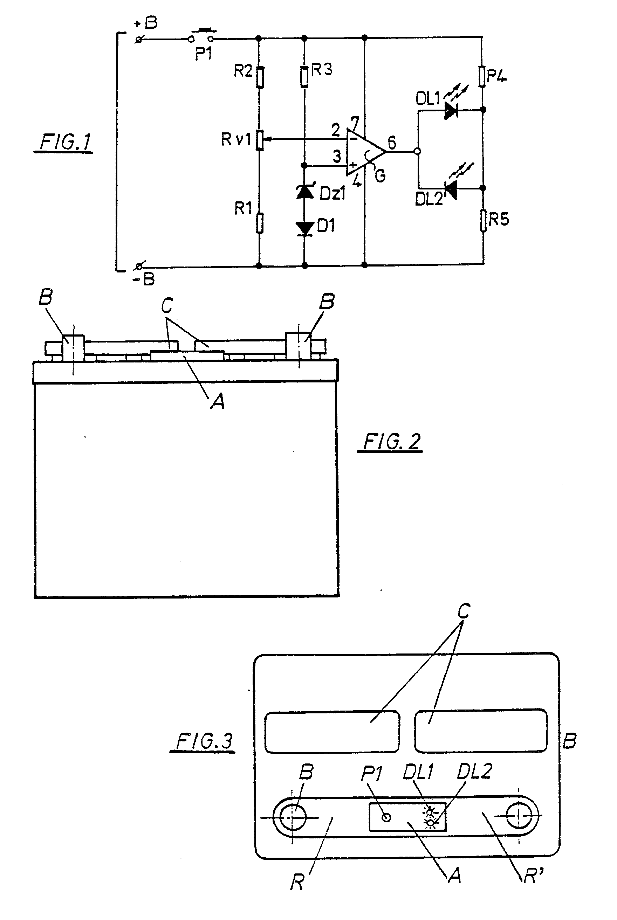

Referring to figure 1, in which the electronic circuit is illustrated arranged into a hermetical housing, it can be seen that the terminals of the battery are referenced +B and −B, and from these the circuit is supplied through the push button P1.

In continuation, there are two series circuits, one of which is formed by the resistors R2, R1 and Rv1. From the sliding point Rv1, a signal is obtained that is proportional to the voltage of the battery, that is, it will change in the same proportion as the battery voltage and therefore it will be an exact indication of the changes that must be detected.

The second series is formed by the resistor R3, the Zener diode Dz1 and the silicon diode D1. In this case the voltage at the cathode of the Zener diode relative to the negative terminal, is the sum of the voltage drop in both diodes and is stable within wide limits of variation in the voltage of the battery.

The potential difference between points 2 and 3 corresponding to the above-mentioned series circuits, is a differential voltage establishing in either directions according to the setting point of the potentiometer Rv1 which is in relation with the kind of battery.

This differential voltage is applied to the amplifier G, of the galvanic coupling type and supplied by the battery through the points 4 and 7. At the exit of this amplifier, two luminescent diodes are provided, DL1 red coloured and DL2 green coloured, connected in opposition at the central point of two resistors R4 and R5 having the same value and such that they reduce the current for the diodes LED to the required value as a function of the battery so that they light properly and do not deteriorate.

When the voltage in the variable point of the series R2, Rv1 and R1 or point 2, is lower than that of the diodes Dz1 and D1 or point 3, the amplifier will act according to the potential referenced +y −y so that the exit 6 is high in voltage relative to the joining point of R4 and R5, and the diode DL1 placed in this direction of polarization will light, indicating with the red colour that the battery is low in charge relative to the present value with Rv1.

A small difference of potential in the points 2 and 3 of the amplifier in the other direction, will produce a reversal of the voltage in 6, so that DL1 will extinguish and DL2 will light, indicating that the preset threshold has been passed and the battery is in order.

This circuit, having a very reduced size, since the more complex component, the amplifier, is an integrated circuit and therefore reduced in size, is introduced into a tight housing and isolated from the inclemency of the weather and the electrolyte of the battery, so that its location does not entail any difficulty.

In figure 2, an elevation is illustrated of a battery upon which the housing A is arranged, with the circuit of figure 1, being represented the known elements, such as the terminals B and the lids of the vessels C.

In figure 3 the cover of the same battery is represented, illustrating the housing A, upon which the push button P1 and the indicators DL1 and DL2 are arranged.

In figure 3, the references R and R′ represent the elements for the support and the supply of the circuit.

Having fully described the nature of the present invention, as well as the way to realize it, it is to be noted that modifications in the details of the described arrangements can be introduced, in that they do not change the basic principles.

## Claim

An electric battery comprising a box or container into which the electric elements are arranged, said box or container presenting, preferably in the upper lid, a hermetically closed housing (A) into which a plurality of interconnected electronic components are placed, said components forming a circuit comprising a voltage comparator (G) which compares a fixed and stable voltage, produced from the battery, with another voltage proportional to the output voltage of the battery, said comparator (G) controlling signalling means (DL1, DL2) which indicate the condition of a low charge or the good condition of the charge of said battery, characterized in that the said circuit contained in the said hermetical housing (A) comprises a resistive voltage divider (RV1) with its central point preferably adjustable, applied to one (2) of the inputs of said voltage comparator (G), to the other input (3) of which is coupled the stable voltage produced by a Zener diode (DZ1) in series with a silicon diode (D1) and supplied by a resistor (R3), the output (6) of the said comparator (G) being connected to two luminescent diodes (DL1, DL2) of differnt colours in parallel and with inverted polarity at the joining point of two resistors (R4, R5) connected with the other terminal respectively to the positive (+B) and the negative poles (−B) of the battery, all the said circuit being supplied by the terminals (+B, −B) of the battery through a push-button switch (P1) actuatable for checking purposes.

## Patentanspruch

Elektrische Batterie mit einem Gefäss bzw. Behälter, in welchem die elektrischen Elemente angeordnet sind, wobei dieses Gefäss bzw. dieser Behälter, vorzugsweise im Deckel, ein hermetisch geschlossenes Gehäuse (A) aufweist, in welchem eine Anzahl miteinander verbundener elektronischer Komponenten untergebracht ist, wobei diese Komponenten eine Schaltung mit einem Spannungskomparator (G) bilden, welcher eine fixe, stabile, mittels der Batterie erzeugte Spannung mit einer zweiten, zur Ausgangsspannung der Batterie proportionalen Spannung vergleicht, und wobei dieser Komparator (G) Anzeigemittel (DL1, DL2) steuert, die einen niedrigen Ladungszustand bzw. einen genügenden Ladungszustand der Batterie angeben, dadurch gekennzeichnet, dass die im hermetischen Gehäuse (A) enthaltene Schaltung einen ohmschen Spannungsteiler (RV1) mit vorzugsweise einstellbarem Mittelpunkt aufweist, der an einem (2) der Eingänge des genannten Spannungskomparators (G) angeschlossen ist, an dessen anderem Eingang (3) eine stabile, von einer durch einen Widerstand (R3) gespeisten Zenerdiode (DZ1) in Serie mit einer Siliziumdiode (D1) erzeugte Spannung anliegt, wobei der Ausgang (6) des genannten Komparators (G) über zwei parallel und mit unterschiedlicher Polarität geschaltete Leuchtdioden (DL1, DL2) verschiedener Farben mit der Verbindungsstelle zweier Widerstände (R4, R5) verbunden ist, die mit ihrem anderen Anschluss am positiven (+B) bzw. negativen (−B) Pol der Batterie angeschlossen sind, und wobei die gesamte Schaltung von den Anschlussklemmen der Batterie (+B, −B) über einen zu Prüfzwecken bedienbaren Tastschalter (P1) gespeist wird.

**Revendication**

Batterie électrique comprenant une boîte ou bac dans laquelle les éléments électriques sont disposés, cette boîte ou bac présentant, de préférence dans le couvercle supérieur, un logement (A) hermétiquement fermé dans lequel sont placés une pluralité de composants électroniques interconnectés, ces composants formant un circuit comprenant un comparateur de voltage (G) qui compare un voltage fixe et stable produit par la batterie, avec un autre voltage proportionnel au voltage de sortie de la batterie, ce comparateur (G) contrôlant des moyens de signaux (DL1, DL2) qui indiquent les conditions de faible charge ou les bonnes conditions de charge de la batterie, caractérisée en ce que le circuit contenu dans le logement (A) hermétique comprend un diviseur de voltage résistif (RV1) dont le point central est de préférence ajustable, appliqué à l'une (2) des sorties du comparateur de voltage (G), à l'autre sortie (3) duquel est couplé le voltage stable produit par une diode Zener (DZ1) en série avec une diode au silicium (D1) et alimenté par une résistance (R3), la sortie (6) du comparateur (G) étant connectée à deux diodes luminescentes (DL1, DL2) en parallèle de couleurs différentes et avec des polarités inversées au point de jonction de deux résistances (R4, R5) connectées avec l'autre borne respectivement au pôle positif (B+) et au pôle négatif (B−) de la batterie, la totalité du circuit étant alimentée par les bornes (B+, B−) de la batterie à travers un interrupteur (P1) poussebouton actionnable aux fins de contrôle.

_FIG.1_

_FIG. 2_

_FIG.3_